(19) Europäisches Patentamt / European Patent Office / Office européen des brevets

(11) **EP 4 388 305 B1**

(12) **EUROPÄISCHE PATENTSCHRIFT**

(45) Veröffentlichungstag und Bekanntmachung des Hinweises auf die Patenterteilung:
**15.10.2025   Patentblatt 2025/42**

(21) Anmeldenummer: **22761533.3**

(22) Anmeldetag: **08.08.2022**

(51) Internationale Patentklassifikation (IPC):
**G01N 24/08** (2006.01)       **G01R 33/44** (2006.01)
**G01R 33/28** (2006.01)       **G01R 33/56** (2006.01)

(52) Gemeinsame Patentklassifikation (CPC):
**G01N 24/08; G01R 33/44;** G01N 24/088;
G01R 33/282; G01R 33/5605

(86) Internationale Anmeldenummer:
**PCT/EP2022/072248**

(87) Internationale Veröffentlichungsnummer:
**WO 2023/020877 (23.02.2023 Gazette 2023/08)**

(54) **VERFAHREN ZUM QUANTITATIVEN BESTIMMEN EINER WIRTSMOLEKÜL-KONZENTRATION (CTOT) AN WIRTSMOLEKÜLEN UND KONZENTRATIONSMESSGERÄT**

METHOD FOR QUANTITATIVELY DETERMINING A HOST-MOLECULE CONCENTRATION (CTOT) OF HOST MOLECULES, AND CONCENTRATION MEASUREMENT DEVICE

PROCÉDÉ DE DÉTERMINATION QUANTITATIVE D'UNE CONCENTRATION DE MOLÉCULE HÔTE (CTOT) DE MOLÉCULES HÔTES, ET DISPOSITIF DE MESURE DE CONCENTRATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität:  **16.08.2021   DE 102021121238**

(43) Veröffentlichungstag der Anmeldung:
**26.06.2024   Patentblatt 2024/26**

(73) Patentinhaber: **Bundesrepublik Deutschland, vertr. durch das Bundesministerium f. Wirtschaft und Technologie, 38116 Braunschweig (DE)**

(72) Erfinder:
• **MITSCHANG, Lorenz**
  **10119 Berlin (DE)**
• **KILIAN, Wolfgang**
  **12355 Berlin (DE)**
• **KORCHAK, Sergey**
  **37085 Göttingen (DE)**

(74) Vertreter: **Gramm, Lins & Partner Patent- und Rechtsanwälte PartGmbB Frankfurter Straße 3c 38122 Braunschweig (DE)**

(56) Entgegenhaltungen:
**EP-A1- 3 330 729**

• **KORCHAK S. ET AL: "Quantitative biosensor detection by chemically exchanging hyperpolarized 129 Xe", PHYSICAL CHEMISTRY CHEMICAL PHYSICS, vol. 20, no. 3, 19 December 2017 (2017-12-19), pages 1800 - 1808, XP055982323, ISSN: 1463-9076, DOI: 10.1039/ C7CP07051A**
• **KUNTH MARTIN ET AL: "Mapping of Absolute Host Concentration and Exchange Kinetics of Xenon Hyper-CEST MRI Agents", PHARMACEUTICALS, vol. 14, no. 2, 21 January 2021 (2021-01-21), pages 79, XP055982197, DOI: 10.3390/ph14020079**

• M. KUNTH ET AL: "Quantitative chemical exchange saturation transfer with hyperpolarized nuclei (qHyper-CEST): Sensing xenon-host exchange dynamics and binding affinities by NMR", THE JOURNAL OF CHEMICAL PHYSICS, vol. 141, no. 19, 21 November 2014 (2014-11-21), US, pages 194202, XP055372198, ISSN: 0021-9606, DOI: 10.1063/ 1.4901429

## EP 4 388 305 B1

**Beschreibung**

Die Erfindung betrifft ein Verfahren zum quantitativen Bestimmen einer Wirtsmolekül-Konzentration an Wirtsmolekülen gemäß dem Oberbegriff von Anspruch 1.

Gemäß einem zweiten Aspekt betrifft die Erfindung ein Konzentrationsmessgerät gemäß dem Oberbegriff von Anspruch 13.

Ein Verfahren zur quantitativen Analyse mittels $^{129}$Xe ist aus dem Artikel "Quantitative biosensor detection by chemically exchanging hyperpolarized 129Xe von S. Korchak et al, Phys. Chem. Chem. Phys, 2018, 20, 1800 und aus der EP 3 330 729 A1 bekannt. Es beruht auf der Wechselwirkung von Xenon-Atomen mit molekularen Wirtsmolekülen und kann durch Kernspinresonanz Einblicke aus Sicht der Grundlagenchemie als auch der biomedizinischen Analytik und Bildgebungstechnik liefern. Xenon bildet reversible Wirtsmolekül-Xenon-Komplexe, die mittels Kernspinresonanz (nuclear magnetic resonance, NMR) nachweisbar sind.

Umfasst das Wirtsmolekül - wie gemäß einer bevorzugten Ausführungsform vorgesehen - einen Rezeptormolekülabschnitt zum Binden eines Ziel-Moleküls und ein Einlagerungsmolekülabschnitt, der besonders einfach Xenon einlagert, können zudem eine Vielzahl von Ziel-Molekülen quantitativ bestimmt werden. Für den Rezeptormolekülabschnitt kommen insbesondere Enzyme, Antikörper oder Fragmente davon in Frage, die hoch spezifisch und effektiv die jeweiligen Liganden (Substrat, Antigen) als Ziel-Molekül binden. Umgekehrt kommen auch Liganden als Rezeptormolekülabschnitt für ein Xenon-Wirtsmolekül in Frage, um ein passendes Enzym oder Antikörper als Ziel-Molekül zu binden. Für den Einlagerungsmolekülabschnitt haben sich organische Gastmoleküle wie Cucurbit[6]urile, Cryptophane oder Pillararene bewährt, aber auch Xenon-bindende Proteine oder Peptide sind hier verwendbar.

Xenon ist inert und ungiftig und bei Laborbedingungen gasförmig, es löst sich leicht in wässrigen und physiologischen Flüssigkeiten und zeigt für jede spezifische Bindungsstelle eine eindeutige Resonanzfrequenzverschiebung. Vorzugsweise kann ein Isotopengemisch mit dem Isotop $^{129}$Xe in natürlicher Häufigkeit (ca. 26%) oder in Anreicherung (bis über 90%) vorliegen. Wird - wie gemäß einer bevorzugten Ausführungsform vorgesehen - das hyperpolarisierte $^{129}$Xe (hpXe) durch optisches Pumpen (spin exchange optical pumping, SEOP) präpariert, ergibt sich eine um Größenordnungen erhöhte Nachweisempfindlichkeit.

Ein weiterer Empfindlichkeitsgewinn ergibt sich durch den - gemäß einer bevorzugten Ausführungsform vorgesehenen - Einsatz von NMR-Sättigungstransfertechniken, bei denen die Anwesenheit des Wirtsmoleküls indirekt beobachtet wird (hyperpolarized xenon chemical exchange saturation transfer, HyperCEST). Die Depolarisierung von wirtsmolekülgebundenem hpXe durch selektive Bestrahlung mit der Depolarisierungs-Strahlung, die eine Hochfrequenz (HF-) Bestrahlung ist, erzwingt den gleichzeitigen kontinuierlichen Abfall des Signals gelösten hpXe aufgrund des Ortsaustauschs von Xenon-Atomen aus der Lösung in den Wirtsmolekül-Xenon-Komplex und umgekehrt.

Während HyperCEST für qualitative Studien gut etabliert ist, ist es bislang nicht möglich, die Wirtsmolekül-Konzentration mit akzeptabler Unsicherheit und ohne umfangreiches, spezifisches Vorwissen zu bestimmen. Als schwierig bei der Messung der Wirtsmolekül-Konzentration haben sich die stark asymmetrischen Austauschraten aufgrund der deutlich unterschiedlichen Konzentrationen von gelöstem und im Wirtsmolekül-Xenon-Komplex gebundenem Xenon, das Vorherrschen mehrerer Reaktionsmechanismen und die Beschränkung auf das eine Signal des gelösten Xenons herausgestellt.

Der Erfindung liegt die Aufgabe zugrunde, die Bestimmung der Wirtsmolekül-Konzentration mittels hyperpolarisiertem Xenon zu verbessern, insbesondere in Hinblick auf Richtigkeit, Genauigkeit und erforderlichem Vorwissen.

Die Erfindung löst das Problem durch ein Verfahren mit den Merkmalen von Anspruch 1.

Gemäß einer bevorzugten Ausführungsform wird die Xenon-Konzentration ($\rho$) durch den Xenon-Partialdruck (p) in einem Gas, das mit der Lösung im Austauschgleichgewicht steht, bestimmt. Insbesondere wird sie als Produkt einer Xenon-Löslichkeit (s) von Xenon in der Lösung und dem Xenon-Partialdruck (p) in einem Gas, das mit der Lösung im Austauschgleichgewicht steht, gemäß dem Henry'schen Gesetz ermittelt.

Gemäß einem zweiten Aspekt löst die Erfindung das Problem durch ein Konzentrationsmessgerät mit den Merkmalen von Anspruch 12.

Vorteilhaft an der Erfindung ist, dass allein aus den Messdaten, die von der Magnetresonanzmesseinheit gemessen werden, die Wirtsmolekül-Konzentration berechnen zu können. Das erleichtert in der Regel die Messung der Wirtsmolekül-Konzentration. Etablierte Verfahren erfordern Kalibrierungen an Referenzmaterial möglichst ähnlich der Probe allerdings bei genau bekannter Wirts- und/oder Zielmolekülkonzentration, was - insbesondere bei biologischem Material - oft nicht oder nur in unbefriedigender Qualität erreicht werden kann.

Vorteilhaft ist zudem, dass in vielen Fällen eine quantitative Bestimmung der Wirtsmolekül-Konzentration mit einer so geringen Messunsicherheit möglich wird, dass quantitative Forschung an solchen Wirtsmolekülen möglich wird. Das gilt insbesondere, wenn das Wirtsmolekül einen Rezeptormolekülabschnitt aufweist, sodass das interessierende Biomolekül als Ziel-Molekül gebunden werden kann.

Im Rahmen der vorliegenden Beschreibung wird unter einem Wirtsmolekül ein Molekül verstanden, das mit Xenon einen Wirtsmolekül-Xenon-Komplex bildet.

Unter dem Merkmal, dass die Signalintensität des Hochfrequenzsignals im Frequenzintervall um die Resonanz-Frequenz des gelösten Xenons gemessen wird, wird insbesondere verstanden, dass im Magnetresonanzspektrum die Fläche des Peaks bestimmt wird.

Die Wirtskomplex-Frequenz ist die Larmor-Frequenz für Xenon im Komplex mit dem Wirtsmolekül.

Unter dem Merkmal, dass das Xenon im Wirtsmolekül-Xenon-Komplex selektiv depolarisiert wird, wird verstanden, dass die Frequenz der Depolarisierungs-Strahlung gleicher Wirtskomplex-Frequenz gewählt ist, so dass gelöstes Xenon möglichst gering oder gar nicht depolarisiert wird.

Vorzugsweise wird die Wirtsmolekül-Konzentration allein aus den Signalintensitäten, den Xenon-Konzentrationen, den Bestrahlungsamplituden und ggf. den Bestrahlungszeiten bestimmt. Hierunter ist insbesondere zu verstehen, dass bei der Bestimmung der Wirtsmolekül-Konzentration keine anderen physikalischen Größen verwendet werden, die mittels eines anderen Verfahrens gemessen werden.

Gemäß einer bevorzugten Ausführungsform ist die Xenon-Konzentration ($\rho$) durch den Xenon-Partialdruck (p) in einem Gas, das mit der Lösung im Austauschgleichgewicht steht, bestimmt. Insbesondere wird sie als Produkt einer Xenon-Löslichkeit (s) von Xenon in der Lösung und dem Xenon-Partialdruck (p) in einem Gas, das mit der Lösung im Austauschgleichgewicht steht, gemäß dem Henry'schen Gesetz ermittelt. Die Xenon-Löslichkeit s des Xenons in einer Lösung ist für eine große Vielzahl an Lösungen, insbesondere physiologischen Lösungen wie Blut, Urin oder Hirnflüssigkeit und insbesondere für alle praktisch relevanten Lösungsmittel aus der Literatur mit geringer Messunsicherheit bekannt. Es ist möglich und gemäß einer bevorzugten Ausführungsform vorgesehen, dass diese Xenon-Löslichkeit beispielsweise in einem digitalen Speicher der Recheneinheit gespeichert ist.

Vorzugsweise umfasst das Verfahren die Schritte (a) Messen von Signalintensitäten S($\rho$,v,t) bei unterschiedlichen Xenon-Konzentrationen ($\rho$) und unterschiedlichen Bestrahlungsamplituden (v) je zu zumindest zwei unterschiedlichen Zeitpunkten (t) während des Bestrahlens , (b) Berechnen einer effektiven zeitlichen Abklingrate $\delta$($\rho$,v) aus den Signalintensitäten S($\rho$,v,t) für gegebene Xenon-Konzentration und Bestrahlungsamplitude und (c) Berechnen einer Xenonaustrittsrate k$_{on}$($\rho$) und einer Xenoneintrittsrate k$_{on}$($\rho$) in Abhängigkeit von der Xenon-Konzentration ($\rho$). Das erfolgt vorzugsweise durch Anpassen der effektiven Abklingraten $\delta$($\rho$,v) mittels Quadratfehlerminimierung an die Formel

$$\delta(\rho, v) = k_{on}(\rho) \frac{(2\pi v)^2}{(2\pi v)^2 + k_{off}(\varrho)^2} \ .$$

. Danach wird vorzugsweise die Wirtsmolekül-Konzentration C$^{tot}$ an Wirtsmolekülen durch Anpassen, insbesondere mittels Quadratfehlerminimierung der Xenonaustrittsraten k$_{off}$($\rho$) und der Xenoneintrittsraten k$_{on}$($\rho$) an die Formel

$\frac{k_{off}(\rho)}{k_{on}(\rho)} = \frac{1}{KC^{tot}} + \frac{1}{C^{tot}}\rho$   berechnet.

Unter dem Anpassen der angegebenen Parameter, nämlich Xenonaustrittsraten k$_{off}$($\rho$) und der Xenoneintrittsraten k$_{on}$($\rho$), an die angegebene Formel, wird verstanden, dass auf bekannte Weise, beispielsweise mittels des Levenberg-Marquardt-Algorithmus, die Parameter so variiert werden, dass die Abweichung zwischen den Messdaten und der Ausgleichskurve, die durch die Formel angegeben ist, minimal wird. Die Abweichung wird vorzugsweise durch Summieren der quadratischen Abweichung zwischen dem jeweiligen Messwert und dem Funktionswert bestimmt.

Unter dem Merkmal, dass die Wirtsmolekül-Konzentration durch das Anpassen an die angegebene Formel bestimmt wird, wird insbesondere verstanden, dass eine mathematische Operation durchgeführt wird, die diesem Anpassen entspricht. Es ist stets möglich, beispielsweise durch eine Substitution einer Variablen durch eine andere Variable, andere Formeln zum Anpassen zu verwenden. Eine derartige Rechnung ist aber äquivalent zum Anpassen an die oben genannte Formel.

Es ist zudem entbehrlich, dass die Xenonaustrittsraten und die Xenoneintrittsraten explizit berechnet werden. Es ist vielmehr ausreichend, dass Zahlenwerte berechnet werden, aus denen, beispielsweise durch Hinzumultiplizieren eines Faktors oder Hinzuaddieren eines Summanden, ohne weiteres Durchführen einer Quadratfehlerminimierung die Xenonaustrittsraten und die Xenoneintrittsraten berechnet werden können.

Vorzugsweise umfasst das Verfahren zudem den Schritt des Bestimmens einer Bindungskonstanten K, die eine Bindungsstärke von Xenon an das Wirtsmolekül beschreibt, durch Anpassen mittels Quadratfehlerminimierung an die Formel

$$\frac{k_{off}(\rho)}{k_{on}(\rho)} = \frac{1}{KC^{tot}} + \frac{1}{C^{tot}}\rho.$$

Vorzugsweise werden zudem ein Dissoziationsratekoeffizient c_ und/oder ein Ratekoeffizient k für den degenerierten Austausch durch Anpassen mittels Quadratfehlerminimierung an die Formel k$_{off}$($\rho$) = c_ + k$\rho$ bestimmt.

Es ist alternativ auch möglich, die Wirtsmolekül-Konzentration $C^{tot}$ und gegebenenfalls die Wirtsmolekül-Konzentration $C^{tot}$, den Dissoziationsratekoeffizienten $c_-$, den Ratekoeffizienten k für den degenerierten Austausch und die Bindungskonstante K durch Anpassen der effektiven Abklingraten $\delta(\rho,v)$ mittels Quadratfehlerminimierung an die

Formel $\delta(\rho,v) = (c_- + k\rho)\dfrac{KC^{tot}}{1+K\rho}\dfrac{(2\pi v)^2}{(2\pi v)^2+(c_-+k\rho)^2}$ zu berechnen.

Auch ohne das Einstrahlen der Depolarisierungs-Strahlung nimmt die Hyperpolarisierung mit der Zeit durch natürlichen Zerfall ab. Der dadurch bedingte exponentielle Abfall der Polarisierung kann durch eine Referenz-Abklingrate $R(\rho,v)$ beschrieben werden. Um diese Referenz-Abklingrate $R(\rho,v)$ zu bestimmen, umfasst das Verfahren vorzugsweise die Schritte (a) Messen einer Referenz-Signalintensität $S_R(\rho,v,t)$ bei unterschiedlichen Xenon-Konzentrationen $\rho$ des gelösten Xenons und unterschiedlichen Bestrahlungsamplituden v und -zeiten t bei einer Spiegelsymmetrie-Frequenz fs , die die Summe ist aus (i) einer Resonanz-Frequenz des gelösten Xenons und (ii) der Differenz aus der Resonanz-Frequenz und der Wirtskomplex-Frequenz, und (b) Berechnen einer zeitlichen Referenz-Abklingrate $R(\rho,v)$ aus den Referenz-Signalintensitäten $S_R(\rho,v,t)$. Es werden dabei die gleichen Xenon-Konzentration und Bestrahlungsamplituden verwendet wie beim Bestimmen der Signalintensitäten $S(\rho,v,t)$. Die Rate $R(\rho,v)$ beinhaltet zudem die ggf. geringfügige Depolarisation des gelösten Xenons während Einstrahlung mit der Wirtskomplex-Frequenz zur Depolarisierung von Xenon im Komplex mit dem Wirtsmolekül.

Zur Verminderung der systematischen Messunsicherheit ist es günstig, wenn die Referenz-Abklingrate von der effektiven zeitlichen Abklingrate $\delta(\rho,v)$ abgezogen wird. In den meisten Fällen ist die Referenz-Abklingrate $R(\rho,v)$ klein gegenüber der effektiven zeitlichen Abklingrate $\delta(\rho,v)$. Bedeutsam kann diese Korrektur aber dann werden, wenn die Wirtsmolekül-Konzentration sehr klein ist. Mit der so korrigierten Abklingrate $(\delta(\rho,v) - R(\rho,v))$ können dann, wie oben beschrieben, die Wirtsmolekül-Konzentration $C^{tot}$ und gegebenenfalls die anderen Koeffizienten berechnet werden.

Anstatt die Wirtsmolekül-Konzentration $C^{tot}$ und andere Parameter aus den effektiven Abklingzeiten gemäß den beiden zuvor beschriebenen Alternativen zu berechnen, ist es als weitere Alternative oder zusätzlich möglich, diese Parameter direkt aus den Signalintensitäten zu berechnen. Dazu werden zunächst die Signalintensität S(p,v,t) bei unterschiedlichen Xenon-Konzentrationen (p), unterschiedlichen Bestrahlungsamplituden (v) und unterschiedlichen Zeitpunkten (t) gemessen, sodass zeitabhängige Signalintensitäts-Messdaten erhalten werden. Danach werden die so erhaltenen Signalintensität-Messdaten mittels Quadratfehlerminimierung an die Formel

$$S(\rho,v,t) \propto \frac{A\rho}{1+a\rho}\exp\left\{-\left(\frac{(c_-+k\rho)KC^{tot}}{1+K\rho}\frac{(2\pi v)^2}{(2\pi v)^2+(c_-+k\rho)^2}+R(\rho,v)\right)t\right\}$$

angepasst, wobei vorzugsweise zudem der Dissoziationsratekoeffizient $c_-$, der Ratekoeffizient k für den degenerierten Austausch, die Bindungskonstante K, eine gerätespezifische Signalamplitude A und ein Parameter $\alpha$, der die Generierung der Hyperpolarisation beschreibt, bestimmt werden. Optional kann je nach erforderlicher Genauigkeit die Referenz-Abklingrate $R(\rho,v)$ vernachlässigt, oder wie oben beschrieben bestimmt und berücksichtigt werden. Die in der Formel genannte Zeit t beginnt mit dem Einstrahlen der Depolarisierungs-Strahlung.

Gemäß einer bevorzugten Ausführungsform ist die Xenon-Konzentration (p) des gelösten Xenons das Produkt aus dem Partialdruck des Xenons (p) in einer Gasatmosphäre, die im Austauschgleichgewicht mit der Lösung steht und der Löslichkeit (s) des Xenons in der Flüssigkeit beim Partialdruck p. In der Regel ist die Löslichkeit s vom Partialdruck unabhängig, so dass die Ersetzung p=sp für die vorgenannten Formeln der alternativen Vorgehensweisen gilt (ihre Herleitung folgt weiter unten).

Sofern die Konzentration eines Stoffes bestimmt werden soll, der mit Xenon keinen Wirtsmolekül-Xenon-Komplex bildet, ist es günstig, wenn das Wirtsmolekül einen Rezeptormolekülabschnitt zum Binden eines Ziel-Moleküls, einen Einlagerungsmolekülabschnitt und das Ziel-Molekül aufweist. Der Einlagerungsmolekülabschnitt hat eine solche Struktur, dass Xenon eingelagert werden kann. Beispielsweise ist der Einlagerungsmolekülabschnitt ein Cucurbituril, ein Cryptophan oder ein Pillararen. Das Ziel-Molekül ist in der Regel nicht kovalent mit dem Rezeptormolekülabschnitt verbunden. Da die Bindung, bei der es sich in der Regel um Wasserstoff-Brückenbindungen und/oder Van-der-Waals-Bindungen handelt, vergleichsweise stark ist, wird das Ziel-Molekül als Teil des Wirtsmoleküls betrachtet.

Besonders vorteilhaft ist die Verwendung von Enzymen oder Antikörpermolekülen (oder Fragmente davon) als Rezeptormolekül aufgrund der hohen Spezifität und Bindungsstärke zu Liganden (Substrat, Antigen) als Ziel-Molekülen. Umgekehrt kann auch ein Ligand als Rezeptormolekülabschnitt dienen, um ein Enzym oder einen Antikörper als Ziel-Molekül zu binden.

Bei einem Konzentrationsmessgerät ist es möglich, dass die Recheneinheit aus zwei oder mehr Teil-Recheneinheiten aufgebaut ist. Vorzugsweise ist die Recheneinheit ausgebildet zum Durchführen eines Verfahrens mit den Schritten (b) bis (e) von Anspruch 1, vorzugsweise mit den in einem oder mehreren Unteransprüchen genannten zusätzlichen Schritten.

Mit dem erfindungsgemäßen Verfahren können Wirtsmolekül-Konzentrationen unterhalb von ein Mikromol pro Liter, teilweise sogar unterhalb von ein Nanomol pro Liter, gemessen werden. Die Messunsicherheit (relative Abweichung) für die Wirtsmolekülkonzentration liegt - je nach Quantifizierungsverfahren (Alternative) - bei weniger 5% bis weniger 20%. Diese Messunsicherheit erscheint vergleichsweise hoch, ist aber für die Quantifizierung vieler Biomarker (Ziel-Moleküle) kleiner als bei bekannten Messverfahren.

Wichtig ist zudem, dass das erfinderische Verfahren nur die experimentellen Vorgaben für die Konzentration gelösten Xenons sowie Bestrahlungsamplitude und Bestrahlungszeit voraussetzt, und nicht wie bei den bekannten Verfahren den Rückgriff auf Referenzmessungen an biologischem Referenzmaterial erfordert, das oft nicht oder nur in unbefriedigender Qualität zur Verfügung steht. Gemäß einer bevorzugten Ausführungsform ist vorteilhaft, wenn die Xenon-Konzentration durch den Xenon-Partialdruck (p) in einer Gasatmosphäre im Austauschgleichgewicht mit der Lösung bestimmt ist, und dabei insbesondere als Produkt (Henrysches Gesetz: p=sp) der Xenon-Löslichkeit (s) mit dem Xenon-Partialdruck (p). Die dem erfinderischen Verfahren zugrundeliegende Variation der Xenon-Konzentration kann dann also einfach durch die Kontrolle des Xenon-Partialdrucks in der Gasatmosphäre erreicht werden. Bei der Lösung handelt es sich um eine gängige Laborlösung (organische und wässrige Lösungen, Puffer) oder auch insbesondere um eine ggf. aufbereitete Körperflüssigkeit, beispielsweise Blut, Urin oder Liquor, für die genaue Angaben über die Xenon-Löslichkeit in einschlägigen Tabellenwerken zu finden sind. Davon unbenommen stehen etablierte metrologische Verfahren zur genauen Bestimmung der Xenon-Löslichkeit in einer gegebenen Lösung zur Verfügung.

Gemäß einer bevorzugten Ausführungsform beträgt die Wirtsmolekül-Konzentration höchstens 500 Nanomol pro Liter, bevorzugt höchstens 100 Nanomol pro Liter, besonders bevorzugt höchstens 10 Nanomol pro Liter, insbesondere bevorzugt höchstens ein Nanomol pro Liter. Besonders bevorzugt beträgt die Wirtsmolekül-Konzentration höchstens 500 Picomol pro Liter, insbesondere höchstens 200 Picomol pro Liter. Bei so geringen Konzentrationen an Wirtsmolekülen kann kein Signal mehr messtechnisch nachgewiesen werden, das von dem Xenon stammt, das Teil des Wirtsmolekül-Xenon-Komplexes ist. Mit dem erfindungsgemäßen Verfahren hingegen ist eine Bestimmung der Wirtsmolekül-Konzentration auch in diesen Fällen möglich.

Vorzugsweise werden die xenonhaltigen Lösungen hergestellt durch Verändern der Xenon-Konzentration. Beispielsweise wird der Partialdruck des Xenons verändert, mit dem Xenon oder ein xenonhaltiges Gasgemisch durch die Lösung geleitet wird. Insbesondere unterscheiden sich die xenonhaltigen Lösungen lediglich in ihren Xenon-Konzentrationen. Vorzugsweise werden weder Wirtsmolekül entfernt noch hinzugefügt noch wird eine Menge an Lösungsmittel der Lösung verändert.

Gemäß einer bevorzugten Ausführungsform wird beim Bestimmen der Wirtsmolekül-Konzentration kein Messsignal verwendet, das vom Xenon im Wirtsmolekül-Xenon-Komplex stammt.

Beispielsweise ist das Wirtsmolekül ein Amyloid. Insbesondere ist das erfindungsgemäße Verfahren ein Verfahren zum Bestimmen einer Amyloid-Konzentration, beispielsweise in einer Körperflüssigkeit.

Im Folgenden wird die Erfindung anhand der beigefügten Zeichnungen näher erläutert. Dabei zeigt

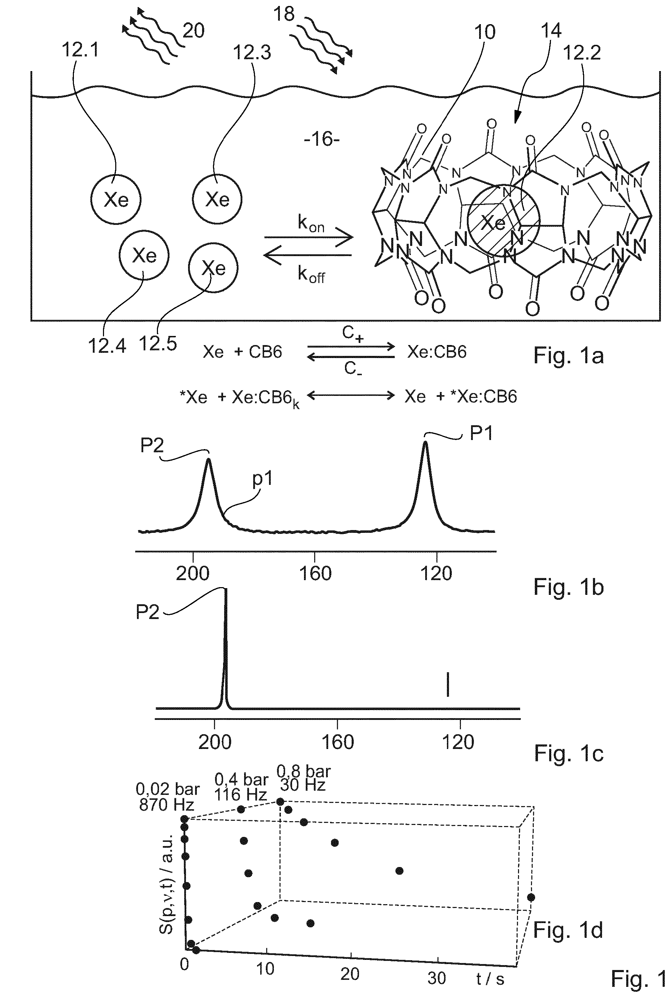

Figur 1    Teilfigur 1a eine schematische Ansicht der Vorgänge beim Xenon-Austausch,

Teilfigur 1b das NMR-Spektrum bei einer hohen Wirtsmolekül-Konzentration in physiologischer Lösung im Austauschgleichgewicht mit einer Gasatmosphäre hyperpolarisierten Xenons,
Teilfigur 1c das NMR-Spektrum bei einer geringen Wirtsmolekül-Konzentration in physiologischer Lösung im Austauschgleichgewicht mit einer Gasatmosphäre hyperpolarisierten Xenons und
Teilfigur 1d auszugsweise den experimentellen Datensatz an Signalintensitäten des gelösten Xenon für eine geringe Wirtsmolekül-Konzentration in physiologischer Lösung bei verschiedenen Xenon-Konzentrationen (p) gelösten Xenons (ausgedrückt durch den Xenon-Partialdruck (p) in einer Gasatmosphäre im Austauschgleichgewicht mit der Lösung nach p=sp mit einer Xenon-Löslichkeit (s)) sowie verschiedenen Bestrahlungsamplituden (v) und -zeiten (t), und

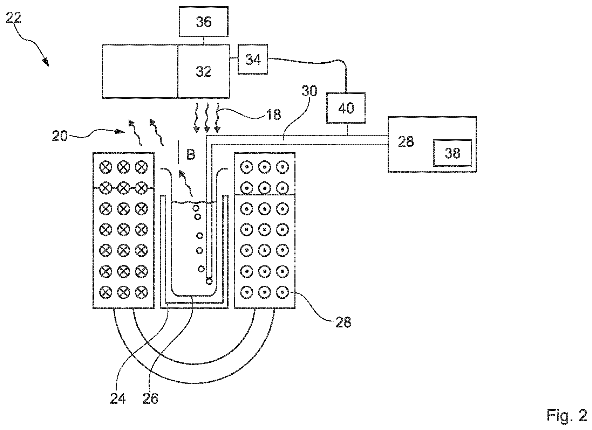

Figur 2    eine schematische Ansicht eines erfindungsgemäßen Konzentrationsmessgeräts, und

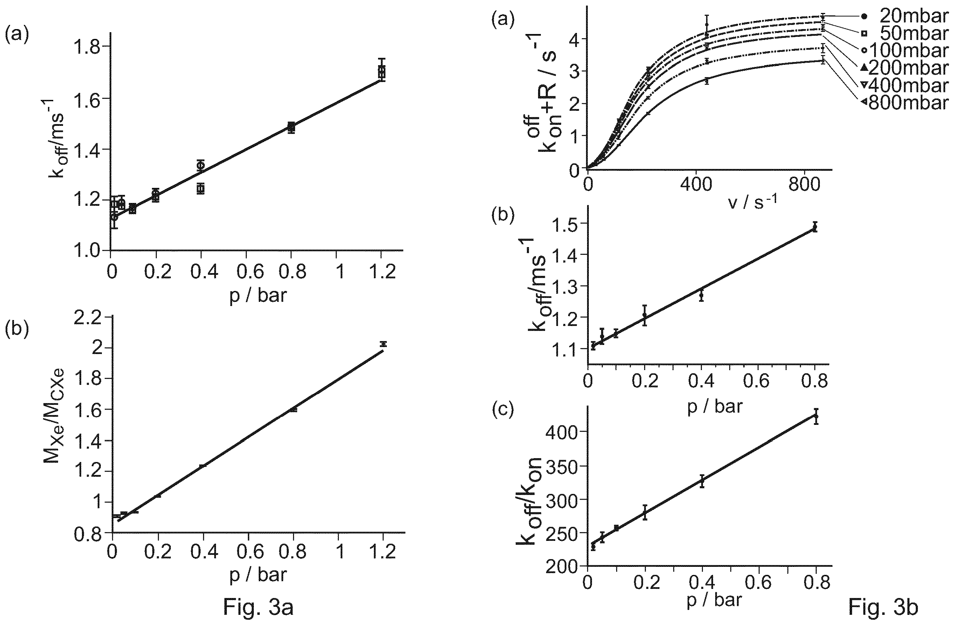

Figur 3a    die quantitative Auswertung von Standard Xenon-NMR-Spektren bei hoher Konzentration von 4,12 mM CB6 (CB6 = Cucurbit[6]uril) in physiologischer Lösung (90% Phosphat-gepufferte Kochsalzlösung, 10% $D_2O$ bei Temperatur 25 °C) im Austauschgleichgewicht mit einer Gasatmosphäre hyperpolarisierten Xenons unter Verwendung einer tabellierten Xenon-Löslichkeit (s=0,00394 $Mbar^{-1}$) und des angewandten Xenon-Partialdruck p zur Bestimmung der Konzentration p=sp gelösten Xenons.

Figur 3b    die quantitative Auswertung gemäß des erfinderischen Verfahrens für 16,5 $\mu$M CB6 in physiologischer Lösung im Austauschgleichgewicht mit einer Gasatmosphäre hyperpolarisierten Xenons durch Anpassung der Modelfunktion nach Gleichung [3] an die effektiven Abklingraten zur Ermittlung der der Eintritts- und Austrittsraten und folgende Bestimmung der Austauschparameter c-, k, K und $C^{tot}$ durch Anpassung der Eintritts- und Austrittsraten an die Modellgleichungen [5] und [9] unter Verwendung einer tabellierten Xenon-Löslichkeit (s=0,00394 Mbar$^{-1}$) und des angewandten Xenon-Partialdruck p zur Bestimmung der Konzentration p=sp gelösten Xenons, und

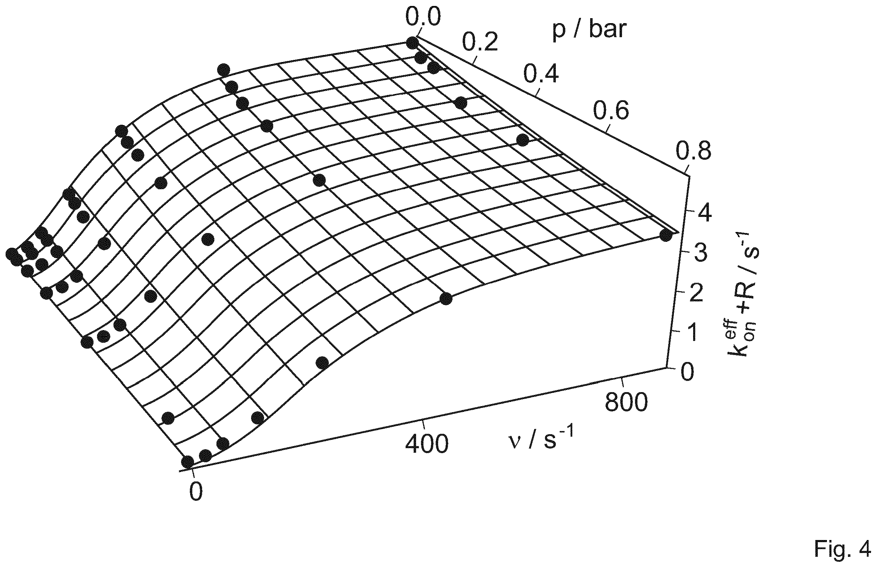

Figur 4    die quantitative Auswertung gemäß des erfinderischen Verfahrens für 16,5 $\mu$M CB6 in physiologischer Lösung im Austauschgleichgewicht mit einer Gasatmosphäre hyperpolarisierten Xenons durch die Anpassung der Modelfunktion nach Gleichung [ 4 ] an die effektiven Abklingraten zur direkten Berechnung der Parameter c-, k, K und C$^{tot}$ unter Verwendung einer tabellierten Xenon-Löslichkeit (s=0,00394 Mbar$^{-1}$) und des angewandten Xenon-Partialdruck p zur Bestimmung der Konzentration p=sp gelösten Xenons.

Die betrachtete Wirts-Gast-Austausch-Situation ist in Figur 1a dargestellt. Ein Wirtsmolekül 10, beispielsweise Cucurbit[6]uril, und ein Xenon-Gastatom 12.1 können einen Wirtsmolekül-Xenon-Komplex 14 bilden. Weitere Xenon-Gastatome 12.j (j= 2,3, ...) sind in einer Lösung 16 gelöst.

Die gelösten Xenon-Gastatome 12.j haben eine Resonanz-Frequenz f$_R$, die ihrer Larmor-Frequenz entspricht, die im Wirtsmolekül 10 gebundenen Xenon-Gastatome resonieren bei der Wirtskomplex-Frequenz fw, die der Larmor-Frequenz des Wirtsmolekül-Xenon-Komplexes 14 entspricht.

Mit einer Xenoneintrittsrate k$_{on}$ treten Xenon-Gasatome 12.j aus der Lösung 16 in einen Wirtsmolekül-Xenon-Komplex 14 ein. Mit einer Xenonaustrittsrate k$_{off}$ treten Xenon-Gasatome 12.j aus dem Wirtsmolekül-Xenon-Komplex 14 aus und gehen in Lösung. Diese Prozesse werden sowohl durch dissoziativen als auch durch entarteten Austausch bestimmt.

Die Lösung 16 wird bei der Wirtskomplex-Frequenz fw mit Depolarisierungs-Strahlung 18 bestrahlt. Dadurch depolarisiert effektiv das Xenon (hier das Xenon-Atom 12.2), das im Wirtsmolekül-Xenon-Komplex gebunden ist.

Das gelöste Xenon gibt ein Hochfrequenzsignal 20 ab, das eine Signalintensität S hat.

Figur 1b zeigt das Spektrum des Hochfrequenzsignals 20 für den Fall einer hohen Wirtsmolekül-Konzentration C$^{tot}$. Es ist zu erkennen, dass das Spektrum zwei Maxima P1, P2 aufweist. Das erste Maximum P1 stammt von Xenon, das im Wirtsmolekül-Xenon-Komplex 14 gebunden ist. Das zweite Maximum P2 stammt von nicht im Wirtsmolekül-Xenon-Komplex 14 gefangenem, gelöstem Xenon.

Wie in der NMR-Messtechnik üblich, sind die Maxima auf eine Referenzfrequenz in ppm (parts per million) normiert, hier das Signal gelösten Xenons auf 196 ppm.

Figur 1c zeigt das Spektrum des Hochfrequenzsignals 20 für den Fall einer sehr kleinen Wirtsmolekül-Konzentration C$^{tot}$. Es ist zu erkennen, dass das erste Maximum P1 nicht mehr nachweisbar ist. Eine Messung der Wirtsmolekül-Konzentration C$^{tot}$ wird stattdessen nach dem erfindungsgemäßen Verfahren anhand der Signalintensität S des gelösten Xenons (P2) ermöglicht (beispielsweise als Fläche unter dem Peak).

Diese Signalintensität S lässt sich beschreiben durch

$$S(\rho,v,t) \propto M_{Xe}(\rho) \exp\left\{-\left(k_{on}^{eff}(\rho,v) + R(\rho,v)\right)t\right\}, \qquad [\,1\,]$$

worin

$$M_{Xe}(p) = A\frac{\rho}{1+a\rho} \qquad [\,2\,]$$

gilt.

Der Amplitudenfaktor M$_{Xe}$ in Gleichung [ 2 ] ist proportional zur Xenon-Konzentration (p) gelösten Xenon durch einen instrumentierungsabhängigen Faktor A und skaliert mit 1/(1+$\alpha\rho$), wobei der Parameter $\alpha$ (Griechisch "alpha") den Grad der durch optisch gepumpten Spinaustausch (spin-exchange opticel pumping, SEOP) erzeugten Hyperpolarisation angibt.

Die effektive Abklingrate hier ist die Summe ( $k_{on}^{eff}(\rho,v) + R(\rho,v)$ ) aus einer durch Austausch mit bestrahlten Wirtsmolekül-Xenon-Komplexen induzierten Sättigungstransferrate $k_{on}^{eff}(\rho,v)$ und einer Referenz-Abklingrate R(p,v), die den natürlichen Zerfalls oder eine direkte Depolarisation durch Bestrahlen beschreibt.

In vielen Fällen ist R(p,v) praktisch unabhängig von der Konzentration gelösten Xenons und oft auch von der Bestrahlungsamplitude (R ist dann die konstante natürliche Zerfallsrate) oder kann ggb. der Sättigungstransferrate aufgrund des Größenunterschieds ganz vernachlässigt werden.

Die durch Austausch mit bestrahlten Wirtsmolekül-Xenon-Komplexen induzierte Sättigungstransferrate (

$k_{on}^{eff}(\rho, v)$ ) lässt sich beschreiben als

$$k_{on}^{eff}(\rho, v) = k_{on}(\rho)f(\rho, v) = k_{on}(\rho)\frac{(2\pi v)^2}{(2\pi v)^2 + k_{off}(\rho)^2} , \qquad [\,3\,]$$

Mit der Eintrittsrate $k_{on}(\rho)$ und der Austrittsrate $k_{off}(\rho)$ für die Bildung und Auflösung des Wirtsmolekül-Xenon-Komplexes. Der Term $f(p,v)$ bezieht sich auf die nur teilweise Sättigung von im Wirtsmolekül-Xenon-Komplex 14 gebundenem Xenon, wenn die Verweilzeit des Xenons im Komplex $1/k_{off}$ bei gegebener Bestrahlungsamplitude $v$ der Depolarisierungs-Strahlung zu klein ist, um eine vollständige Magnetisierungslöschung zu erreichen.

Aus einer analytischen Näherungslösung der Bloch-McConnell-Gleichung für die Sättigung des Spins von Xenon-Atomen in einem Wirtsmolekül-Xenon-Komplex durch resonante Bestrahlung folgt bei vernachlässigbarer Spin-Spin-Relaxationsrate explizit

$$k_{on}^{eff}(\rho, v) = (c_- + k\rho)\frac{KC^{tot}}{1+K\rho}\frac{(2\pi v)^2}{(2\pi v)^2 + (c_- + k\rho)^2} . \qquad [\,4\,]$$

Es gilt also

$$k_{off}(\rho) = c_- + k\rho , \qquad [\,5\,]$$

was die Xenon-Austrittsrate durch Anteile aus dissoziativen Austausch ($c\_$) und degenerierten Austausch ($kp$) beschreibt.

Das kinetische Gleichgewicht für den Austausch der Magnetisierung zwischen den Pools von gelöstem ($M_{Xe}$) und im Wirtsmolekül-Xenon-Komplex 14 gebundenem Xenon ($M_{CXe}$) stellt sich schnell ein. Es gilt daher

$$k_{on} = k_{off} M_{CXe}/M_{Xe.} \qquad [\,6\,]$$

Da alle Xenon-Atome in gleicher Weise von einer gemeinsamen Quelle hyperpolarisiert werden, ist ihre Polarisation in beiden Pools gleich, sodass das Verhältnis der Magnetisierungen von wirtsgebundenen Xenon und gelöstem Xenon gleich dem der Konzentrationen an wirtsgebundenem Xenon und gelöstem Xenon ist

$$M_{CXe}/M_{Xe} = (K\rho/(1+K\rho))C^{tot}/\rho . \qquad [\,7\,]$$

Darin ist K die Bindungskonstante und $C^{tot}$ die Gesamtkonzentration an Wirtsmolekülen. Der Faktor $K\rho/(1+K\rho)$ ist der Anteil der mit Xenon-Atomen besetzten Wirtsmoleküle. Somit gilt für die Xenon-Eintrittsrate explizit

$$k_{on}(\rho, v) = (c_- + k\rho)\frac{KC^{tot}}{1+K\rho}. \qquad [\,8\,]$$

Figur 2 zeigt schematisch ein Konzentrationsmessgerät 22, das eine Probenaufnahme 24 zum Aufnehmen der Lösung 16, beispielsweise in einem Probengefäß 26 aufweist. Das Konzentrationsmessgerät umfasst zudem einen Magneten 42 zum Erzeugen eines Magnetfelds mit einer Stärke von vorzugsweise zumindest 1 Tesla in der Lösung 16.

Zum Einstellen der Xenon-Konzentration $\rho$ wird Xenon mittels einer Einbringvorrichtung 28 in die Lösung gebracht. Beispielsweise wird durch GasEinperlung ein Austauschgleichgewicht zwischen einer Xenon-Gasatmosphäre und der Lösung erreicht, so dass die Xenon-Konzentration (p) gelösten Xenons durch den Xenongasdruck bestimmt ist, insbesondere gleich dem Produkt der Xenon-Löslichkeit (s) mit dem Partialdruck des Xenons im einperlenden Gas (p) ist (Henrysches Gesetz: p=sp).

Die Sättigungstransferrate $k_{on}^{eff}(\rho, v)$ (Gleichung [ 4 ]) wird durch sieben Parameter bestimmt. Die Xenon-Konzentration (p) gelösten Xenons wird durch die Einbringvorrichtung 28 eingestellt, in einer bevorzugten Ausführung durch Gaseinperlung und nach dem Henry'schen Gesetz als p=sp mit der Xenon-Löslichkeit s und dem Xenon-Partialdruck p. Die Bestrahlungsamplitude $v$ wird durch Ansteuern einer Magnetresonanzmesseinheit 32 des Konzentrationsmessgeräts 22 mittels einer Recheneinheit 34 eingestellt.

Die Magnetresonanzmesseinheit 32 ist ausgebildet zum automatischen Bestrahlen der xenonhaltigen Lösung 16 mit der Depolarisierungs-Strahlung 18 und zum Messen der Signalintensität S des Hochfrequenzsignals 20. Die Recheneinheit 34 ist ausgebildet zum automatischen (a) Ansteuern der Magnetresonanzmesseinheit, sodass diese die Depolarisierungs-Strahlung 18 mit einer Wirtskomplex-Frequenz fw und der Bestrahlungsamplitude v abgibt.

Zudem steuert die Recheneinheit die Einbringvorrichtung 28 so an, dass die Xenon-Konzentration p in der Lösung 16 einen vorgegebenen Wert hat. In der Recheneinheit 34 ist ein Messplan gespeichert, der angibt, welche Kombinationen an Xenon-Konzentrationen p und Bestrahlungsamplituden v eingestellt werden sollen.

Danach erfasst die Recheneinheit 34 bei den verschiedenen, aber festen (p, v)-Einstellungen einen Abfall der Signalintensität S(p,v,t) dadurch, dass zu zumindest zwei unterschiedlichen Zeitpunkten der Bestrahlung (t) das Signal des gelösten Xenons gemessen und die Signalintensität bestimmt wird. In anderen Worten wird der Signalabfall, der in Gleichung [ 1 ] beschrieben ist, durch die Signalintensität gelösten Xenons für inkrementierte Sättigungszeit t verfolgt; anschließend kann die jeweilige effektive zeitliche Abklingrate, beispielsweise durch einen monoexponentiellen Datenfit, abgeleitet werden.

Danach berechnet die Recheneinheit 34 automatisch die Wirtsmolekül-Konzentration $C^{tot}$ aus den Signalintensitäten S, den Xenon-Konzentrationen p sowie den Bestrahlungsamplituden v und gegebenenfalls der -zeiten (t). Diese Auswertung wird im Folgenden beschrieben.

Gemäß einer ersten Alternative werden aus den experimentell gemessenen Signalintensitäten für verschiedene, jeweils feste Xenon-Konzentrationen (p) gelösten Xenons und Bestrahlungsamplituden v die effektive Abklingrate mit der Zeit bestimmt. Die Bestimmung der Xenon-Austauschraten $k_{off}(\rho)$ und $k_{on}(\rho)$ werden durch Anpassung an die Modellfunktion [ 3 ] bestimmt. $k_{off}(\rho)$ und $k_{on}(\rho)$, die auf diese Weise für verschiedene Einstellungen von p erhalten werden, gehorchen Gleichungen [ 5 ] bzw. [8] und auch der Gleichung

$$\frac{k_{off}(\rho)}{k_{on}(\rho)} = \frac{1}{KC^{tot}} + \frac{1}{C^{tot}}\rho. \qquad [\,9\,]$$

Die Parameter c_, k, K und $C^{tot}$ werden dann aus dem Achsabschnitt und der Steigung des jeweiligen Datenfits bestimmt.

Gemäß einer zweiten Alternative werden die effektiven Abklingraten unter (p,v)-Variation durch Anpassung an die Modellfunktion

$$k_{on}^{eff}(\rho, \nu) = (c_- + k\rho)\frac{KC^{tot}}{1 + K\rho}\frac{(2\pi\nu)^2}{(2\pi\nu)^2 + (c_- + k\rho)^2}$$

gemäß Gleichung [ 4 ] berechnet und somit die Parameter c_, k, K und $C^{tot}$ direkt bestimmt.

Gemäß einer dritten Alternative werden die Parameter, insbesondere die Wirtsmolekül-Konzentration $C^{tot}$, so gewählt, dass die daraus anhand von Gleichung [ 1 ] berechneten Werte die Messdaten der Signalintensitäten, also die gemessenen, von der Zeit t abhängigen Signalintensitäten, die bei den unterschiedlichen (p,v)-Einstellungen abgetastet werden, mit einer minimalen quadratischen Abweichung wiedergeben.

Die Xenon-Konzentration p gelösten Xenons erscheint nur im Produkt mit unbekannten, nachgesuchten Austauschparametern (mit k und $1/C^{tot}$ in der ersten Alternative; mit k und K in der zweiten Alternative; mit k, K, A und $\alpha$ in der dritten Alternative). In einer bevorzugten Ausführung wird die Xenon-Konzentration durch den Xenon-Partialdruck (p) in einer Gasatmosphäre im Austauschgleichgewicht mit der Lösung bestimmt, insbesondere als Produkt p=sp (Henrysches Gesetz) der Xenon-Löslichkeit (s) mit dem Xenon-Partialdruck (p) berechnet. Für die Löslichkeit s existieren Werte mit geringer Messunsicherheit in der Literatur, die zur Auflösung der Bestimmungsgleichungen für die erste (Gleichungen [3], [ 5 ], [8] und [ 9 ]), zweite (Gleichung [4]) und dritte Alternative (Gleichung [1]) unter der Ersetzung p=sp eingesetzt werden. Alternativ ist die Löslichkeit s für die gegebene Lösung mittels etablierter metrologischer Messungen bestimmbar.

Die drei beschriebenen Alternativen können je nach erforderlicher Genauigkeit für die Quantifizierung der Parameter c_, k, K und $C^{tot}$ um eine Referenz-Abklingrate R(p,v) ergänzt werden, die in Abzug der vorgenannten effektiven Abklingrate gebracht wird (Alternativen 1 und 2) oder explizit berücksichtigt wird (Alternative 3). Sie ergibt sich aus Signalintensitäten bei unterschiedlichen Xenon-Konzentrationen ($\rho$) und unterschiedlichen Bestrahlungsamplituden (v) zu jeweils unterschiedlichen Zeitpunkten der Bestrahlung (t) bei einer Spiegelsymmetrie-Frequenz, die die Summe ist aus (i) einer Resonanz-Frequenz ($f_R$) des gelösten Xenons und (ii) der Differenz aus der Resonanz-Frequenz ($f_R$) und der Wirtskomplex-Frequenz (fw).

Die so bestimmten Parameter c_, k, K und insbesondere die Wirtsmolekül-Konzentration $C^{tot}$, werden danach ausgeben, beispielsweise auf einer schematisch eingezeichneten Anzeige 36.

Figur 2 zeigt zudem, dass das Konzentrationsmessgerät 22 eine Xenon-Hyperpolarisationsvorrichtung 38 aufweisen kann, die Teil der Einbringvorrichtung 28 sein kann. Mittels der Xenon-Hyperpolarisationsvorrichtung 38 wird Xenon hyperpolarisiert. Der Mechanismus dazu ist gut bekannt und wird daher nicht weiter beschrieben. Mittels eines Xenon-Konzentrationsmessers 40 wird die Xenon-Konzentration gelösten Xenons gemessen. In einer bevorzugten Ausführung wird dazu der Xenon-Partialdruck einer Gasmischung im Austauschgleichgewicht mit der Lösung gemessen und zur Bestimmung der Xenon-Konzentration (p) gelösten Xenons, insbesondere als Produkt der Xenon-Löslichkeit (s) mit dem Xenon-Partialdruck (p) gemäß dem Henryschen Gesetz (p=sp), herangezogen. Der Xenon-Konzentrationsmesser 40 ist mit der Recheneinheit 34 verbunden.

Figur 3a zeigt die quantitative Auswertung von Standard Xenon-NMR-Spektren bei hoher Konzentration von 4,12 mM CB6 (CB6 = Cucurbit[6]uril) in physiologischer Lösung, die zur Validierung des erfinderischen Verfahrens dient. Die Xenon-Konzentration (p) gelösten Xenons ist eingestellt mittels Austauschgleichgewicht mit einer Atmosphäre bestimmten Xenon-Partialdrucks (p=0,02 bis 1,2 bar) gemäß p=sp (Henrysches Gesetz) bei einer Xenon-Löslichkeit (s). Da bei diesen Konzentrationen Signale sowohl von gelöstem als auch Komplex gebundenem Xenon vorhanden sind (Fig. 1b), kann das Verhältnis $k_{off}/k_{on}$, das zur Bestimmung von K und $C^{tot}$ führt (Gleichung [9]), direkt als aus den Signalintensitäten gebildet werden gemäß Gleichung [7] unter der Ersetzung p=sp und Verwendung der Löslichkeit s=0,00394 Mbar$^{-1}$ aus der Literatur. Wie kürzlich beschrieben, kann bei hohen Gastmolekülkonzentration auch $k_{off}$ (und damit c_ und k) aus den Signalintensitäten analog Gleichung [5] unter der Ersetzung p=sp und Verwendung der Löslichkeit s=0,00394 Mbar$^{-1}$ aus der Literatur ermittelt werden. Die hohe Konzentration vom 4,12 mM CB6 ist durch Einwaage in der Reinheit bestimmten Ausgangsmaterials hergestellt worden.

Figur 3a zeigt in Teilfigur (a) die Xenonaustrittsrate $k_{off}$ für den CB6-Xenon-Komplex in Abhängigkeit vom Xenon-Partialdruck p. Die Xenonaustrittsraten von Signalen von CB6-gebundenem Xenon sind als Quadrate, die aus Signalen von gelöstem Xenon als Kreise dargestellt.

Figur 3a zeigt in Teilfigur (b) das Verhältnis $M_{Xe}/M_{CXe}$ der Signalintensität von frei gelöstem und CB6-gebundenem Xenon, in Abhängigkeit vom Partialdruck p.

Fehlerbalken in (a) und (b) sind Unsicherheiten aus der Signalintegration. Die Linien stellen lineare Kleinste-Quadrate-Anpassungen der Daten für numerische Schätzungen der Kinetik-Parameter gemäß Gleichung [5] bzw. [9] unter der Ersetzung p=sp dar.

Figur 3b zeigt die quantitative Auswertung gemäß des erfinderischen Verfahrens für 16,5 µM CB6 in physiologischer Lösung. Die Xenon-Konzentration (p) gelösten Xenons ist eingestellt mittels Austauschgleichgewicht mit einer Atmosphäre bestimmten Xenon-Partialdrucks (p=0,02 bis 0,8 bar) gemäß p=sp (Henrysches Gesetz) bei einer Xenon-Löslichkeit (s). Aufgrund der geringen Wirtskonzentration ist der Komplex mit hyperpolarisiertem Xenon nicht als eigenes Signal nachweisbar (Fig. 1c). Die schwach konzentrierte Lösung von nur 16,5 µM CB6 ist aus der hoch konzentrierten Lösung von 4,12 mM durch Verdünnung gewonnen worden.

Die Teilfigur (a) zeigt die effektiven Abklingraten in Abhängigkeit von der Bestrahlungsamplitude v für verschiedene Einstellungen des Partialdrucks p. Die Linien sind nichtlineare Kleinste-Quadrate-Anpassungen der Funktion nach Gleichung [ 3 ] unter der Ersetzung p=sp, um die Xenon-Eintrittsrate $k_{on}$ und die Xenonaustrittsrate $k_{off}$ zu erhalten (Alternative 1). Die Teilfigur (b) zeigt diese Xenonaustrittsrate $k_{off}$ für die Komplexdissoziation in Abhängigkeit vom angelegten Partialdruck p. Die Teilfigur (c) zeigt das Verhältnis $k_{off}/k_{on}$ in Abhängigkeit vom Partialdruck p. Die Linien sind Ausgleichsgeraden für die Berechnung der Parameter gemäß den Gleichungen [ 5 ] und [9] unter der Ersetzung p=sp und Verwendung der Löslichkeit s=0,00394 Mbar$^{-1}$ aus der Literatur. Figur 4 zeigt die Anpassung der Modelfunktion nach Gleichung [ 4 ] unter der Ersetzung p=sp und Verwendung der Löslichkeit s=0,00394 Mbar$^{-1}$ aus der Literatur an die effektiven Abklingraten zur direkten Berechnung der Parameter c-, k, K und $C^{tot}$ (Alternative 2).

In Tabelle 1 sind die numerischen Ergebnisse der Auswertung nach Alternativen 1 und 2 sowie durch Anpassung der Modelfunktion nach Gleichung [ 1 ] an die Signalintensitäten (Alternative 3) unter der Ersetzung ρ=sp und Verwendung der Löslichkeit s=0,00394 Mbar$^{-1}$ aus der Literatur den Referenzwerten aus der hoch konzentrierten CB6 Lösung und der Einwaage gegenübergestellt.

Tab. 1

| Methode \ Parameter | $C_-$ / ms$^{-1}$ | $k$ / M$^{-1}$ms$^{-1}$ | $K$ / M$^{-1}$ | $C^{tot}$ / mM | $C^{tot}$ / mM nach Einwaage |
|---|---|---|---|---|---|
| Standard NMR | 1,12 ± 0,01 | 116 ± 5 | 280 ± 13 | 4,18 ± 0,15 | 4,12 |
| Alternative 1 | 1,10 ± 0,01 | 120 ± 4 | 274 ± 15 | 0,0160 ± 0,0007 | |
| Alternative 2 | 1,10 ± 0,01 | 134 ± 10 | 258 ± 9 | 0,0169 ± 0,0005 | 0,0165 |
| Alternative 3 | 1,18 ± 0,03 | 122 ± 15 | 193 ± 17 | 0,0193 ± 0,0013 | |

## Bezugszeichenliste

| 10 | Wirtsmolekül | A | instrumentierungsabhängiger Faktor |
| 12 | Xenon-Gastatom | | |
| 14 | Wirtsmolekül-Xenon-Komplex | c_ | Dissoziationsratekoeffizient |

(fortgesetzt)

| | | | |
|---|---|---|---|
| 16 | Lösung | $C^{tot}$ | Wirtsmolekül-Konzentration |
| 18 | Depolarisierungs-Strahlung | $f_R$ | Resonanz-Frequenz |
| | | $f_W$ | Wirtskomplex-Frequenz |
| 20 | Hochfrequenzsignal | j | Laufindex Xenon-Atome |
| 22 | Konzentrationsmessgerät | k | Ratekoeffizient |
| 24 | Probenaufnahme | K | Bindungskonstante |
| 26 | Probengefäß | $k_{on}^{eff}$ | Sättigungstransferrate |
| 28 | Einbringvorrichtung | $k_{off}(\rho)$ | Xenonaustrittsrate |
| | | $k_{on}(\rho)$ | Xenoneintrittsrate |
| 30 | einperlendes Gas | $M_{Xe}$ | Amplitudenfaktor |
| 32 | Magnetresonanzmesseinheit | p | Partialdruck |
| 34 | Recheneinheit | $R(p,v)$ | Referenz-Abklingrate |
| 36 | Anzeige | s | Löslichkeit des Xenons im Lösungsmittel der Lösung |
| 38 | Xenon-Hyperpolarisationsvorrichtung | $\rho, s \cdot p$ | Xenon-Konzentration in der Lösung |
| 40 | Xenon-Konzentrationsmesser | $S(\rho,v,t)$ | Signalintensität |
| 42 | Magnet | $S_R(\rho,v,t)$ | Referenz-Signalintensitäten |
| $\alpha$ | Polarisator-Parameter | t | Zeit |
| $\delta(\rho,v)$ | effektive zeitliche Abklingrate | | |
| v | Bestrahlungsamplitude | | |

## Patentansprüche

**1.** Verfahren zum quantitativen Bestimmen einer Wirtsmolekül-Konzentration ($C^{tot}$) an Wirtsmolekülen (10), mit den Schritten:

(a) Einbringen von hyperpolarisiertem Xenon in eine Lösung (16) von Wirtsmolekülen (10), sodass eine xenonhaltige Lösung (16) entsteht, die gelöstes Xenon und Xenon in einem Wirtsmolekül-Xenon-Komplex (14) mit einem Wirtsmolekül (10) enthält,

(b) Bestrahlen der xenonhaltigen Lösung (16) mit elektromagnetischer Depolarisierungs-Strahlung (18) mit einer Wirtskomplex-Frequenz (fw) zum zumindest teilweisen selektiven Depolarisieren von Xenon im Wirtsmolekül-Xenon-Komplex (14), und

(c) danach Messen einer Signalintensität (S) eines Hochfrequenzsignals (20) zumindest in einem Frequenzintervall um eine Resonanz-Frequenz ($f_R$) des gelösten Xenon, zu zumindest zwei unterschiedlichen Zeitpunkten der Bestrahlung (t),

**gekennzeichnet durch** die Schritte:

(d) Bestrahlen von xenonhaltigen Lösungen (16) unterschiedlicher Xenon-Konzentrationen gelösten Xenons mit Depolarisierungs-Strahlung (18) unterschiedlicher Bestrahlungsamplituden (v) und Erfassen der jeweiligen Signalintensitäten (S) und

(e) Bestimmen der Wirtsmolekül-Konzentration ($C^{tot}$) aus den Signalintensitäten (S), den Xenon-Konzentrationen und den Bestrahlungsamplituden (v).

**2.** Verfahren nach Anspruch 1, **dadurch gekennzeichnet, dass**

(a) die Wirtsmolekül-Konzentration ($C^{tot}$) nur aus den Signalintensitäten (S), den Xenon-Konzentrationen (sp) und den Bestrahlungsamplituden (v) bestimmt wird oder

(b) das Bestrahlen der xenonhaltigen Lösungen (16) unterschiedlicher Xenon-Konzentrationen (sp) gelösten Xenons mit Depolarisierungs-Strahlung (18) unterschiedlicher Bestrahlungsamplituden (v) und Bestrahlungszeiten (t) erfolgt und

das Bestimmen der Wirtsmolekül-Konzentration ($C^{tot}$) aus den Signalintensitäten (S), den Xenon-Konzentrationen (sp), den Bestrahlungsamplituden (v) und den Bestrahlungszeiten (t) erfolgt
wobei s die Xenonlöslichkeit und p der Xenonpartialdruck ist.

3. Verfahren nach Anspruch 1 oder 2, **gekennzeichnet durch** die Schritte:

(a) Messen der Signalintensität bei unterschiedlichen Xenon-Konzentrationen (s·*p*) und unterschiedlichen Bestrahlungsamplituden (v) zu jeweils unterschiedlichen Zeitpunkten der Bestrahlung (t), sodass konzentrations-, bestrahlungsamplituden- und zeitabhängige Signalintensitäts-Messdaten (S) erhalten werden,
(b) Berechnen von effektiven zeitlichen Abklingraten ($\delta(p,v)$) aus den Signalintensitäten (S) für gegebene Xenon-Konzentration (sp) und Bestrahlungsamplitude v und
(c) Berechnen einer Xenonaustrittsrate $k_{off}(p)$ und einer Xenoneintrittsrate $k_{on}(p)$ in Abhängigkeit von der Xenon-Konzentration (s·*p*) durch Anpassen der effektiven Abklingraten ($\delta(p,v)$) mittels Quadratfehlerminimierung an die Formel

$$\delta(p,v) = k_{on}(p)\frac{(2\pi v)^2}{(2\pi v)^2 + k_{off}(p)^2},$$

(d) sowie Bestimmen zumindest der Wirtsmolekül-Konzentration $C^{tot}$ an Wirtsmolekülen (10) durch Anpassen der Xenonaustrittsraten ($k_{off}(p)$) und der Xenoneintrittsraten ($k_{on}(p)$) an die Formel

$$\frac{k_{off}(p)}{k_{on}(p)} = \frac{1}{KC^{tot}} + \frac{s}{C^{tot}}p,$$

wobei s die Xenonlöslichkeit ist und K eine Bindungskonstante.

4. Verfahren nach Anspruch 3, **dadurch gekennzeichnet, dass** zudem

(a) eine Bindungskonstante K, die eine Bindungsstärke von Xenon an das Wirtsmolekül (10) beschreibt, durch Anpassen mittels Quadratfehlerminimierung an die Formel

$$\frac{k_{off}(p)}{k_{on}(p)} = \frac{1}{KC^{tot}} + \frac{s}{C^{tot}}p$$

bestimmt wird,
(b) ein Dissoziationsratekoeffizient c_ und
(c) ein Ratekoeffizient (k) k für den degenerierten Austausch durch Anpassen mittels Quadratfehlerminimierung an die Formel

$$k_{off}(p) = c_- + ksp$$

bestimmt wird.

5. Verfahren nach einem der vorstehenden Ansprüche, **gekennzeichnet durch** die Schritte:

(a) Messen der Signalintensität bei unterschiedlichen Xenon-Konzentrationen (s·*p*) und unterschiedlichen Bestrahlungsamplituden (v) zu jeweils unterschiedlichen Zeitpunkten der Bestrahlung (t), sodass konzentrations-, bestrahlungsamplituden- und zeitabhängige Signalintensitäts-Messdaten (S) erhalten werden,
(b) Berechnen der effektiven zeitlichen Abklingraten ($\delta(p,v)$) aus den Signalintensitäten (S) für gegebene Xenon-Konzentration und Bestrahlungsamplitude,
(c) Berechnen

der Wirtsmolekül-Konzentration $C^{tot}$,
des Dissoziationsratekoeffizienten c_,
des Ratekoeffizienten k für den degenerierten Austausch und
der Bindungskonstanten K
durch Anpassen der effektiven zeitlichen Abklingraten ($\delta(p,v)$) an die

$$\text{Formel } \delta(p,v) = (c_- + ksp)\,\frac{KC^{tot}}{1+Ksp}\,\frac{(2\pi v)^2}{(2\pi v)^2+(c_-+ksp)^2}\,.$$

**6.** Verfahren nach einem der vorstehenden Ansprüche, **gekennzeichnet durch**

(a) Messen einer Referenz-Signalintensität bei unterschiedlichen Xenon-Konzentrationen ($s \cdot p$) und unterschiedlichen Bestrahlungsamplituden (v) zu jeweils unterschiedlichen Zeitpunkten der Bestrahlung (t) bei einer Spiegelsymmetrie-Frequenz, die die Summe ist aus (i) einer Resonanz-Frequenz ($f_R$) des gelösten Xenons und (ii) der Differenz aus der Resonanz-Frequenz ($f_R$) und der Wirtskomplex-Frequenz (fw), sodass konzentrations-, bestrahlungsamplituden- und zeitabhängige Referenz-Signalintensitäts-Messdaten ($S_R$) erhalten werden,
(b) Berechnung einer zeitlichen Referenz-Abklingrate (R(p,v)) aus den Referenz-Signalintensitäten ($S_R$) für gegebene Xenon-Konzentration und Bestrahlungsamplitude, und
(c) Abziehen der Referenz-Abklingrate (R(p,v)) von der effektiven Abklingrate ($\delta(p,v)$) für gegebene Xenon-Konzentration (sp) und Bestrahlungsamplitude (v).

**7.** Verfahren nach einem der vorstehenden Ansprüche, **gekennzeichnet durch** die Schritte:

(a) Messen der Signalintensität bei unterschiedlichen Xenon-Konzentrationen (s.p) und unterschiedlichen Bestrahlungsamplituden (v) zu jeweils unterschiedlichen Zeitpunkten der Bestrahlung (t), sodass konzentrations-, bestrahlungsamplituden- und zeitabhängige Signalintensitäts-Messdaten (S) erhalten werden,
(b) Berechnen zumindest der Wirtsmolekül-Konzentration $C^{tot}$,

des Dissoziationsratekoeffizienten $c_-$,
eines Ratekoeffizienten k für den degenerierten Austausch,
der Bindungskonstanten K und
der Signalamplitude A,
eines Parameters $\alpha$, der die Generierung der Hyperpolarisation beschreibt,

durch Anpassen der gemessenen Signalintensitäten mittels Quadratfehlerminimierung an die Formel

$$S(p,v,t) \propto \frac{Asp}{1+ap}\exp\left\{-\left((c_-+ksp)\,\frac{KC^{tot}}{1+Ksp}\,\frac{(2\pi v)^2}{(2\pi v)^2+(c_-+ksp)^2}\right)t\right\}$$

**8.** Verfahren nach Anspruch 7, **gekennzeichnet durch**

(a) Messen zeitabhängiger Referenz-Signalintensitäten ($S_R$) bei unterschiedlichen Xenon-Konzentrationen ($s \cdot p$) und unterschiedlichen Bestrahlungsamplituden (v) zu jeweils unterschiedlichen Zeitpunkten der Bestrahlung (t) bei der Spiegelsymmetrie-Frequenz,
(b) Berechnung der Referenz-Abklingrate in der Zeit (R(p,v)) aus den Referenz-Signalintensitäten ($S_R$) für gegebene Xenon-Konzentration und Bestrahlungsamplitude, und
(c) Anpassen der Signalintensitäten (S) unter Verwendung der Referenz-Abklingrate (R(p,v)) mittels Quadratfehlerminimierung an die Formel

$$S(p,v,t) \propto \frac{Asp}{1+ap}\exp\left\{-\left((c_-+ksp)\,\frac{KC^{tot}}{1+Ksp}\,\frac{(2\pi v)^2}{(2\pi v)^2+(c_-+ksp)^2}+R(p,v)\right)t\right\}.$$

**9.** Verfahren nach einem der vorstehenden Ansprüche, **dadurch gekennzeichnet, dass**

(a) das Wirtsmolekül (10)

einen Rezeptormolekülabschnitt zum Binden eines Ziel-Moleküls,
einen Einlagerungsmolekülabschnitt und
ein Ziel-Molekül, das am Rezeptormolekülabschnitt angebunden ist, aufweist,

(b) der Rezeptormolekülabschnitt ein Protein oder Peptid, insbesondere ein Enzym, ein Antikörper, ein Fragment oder ein Ligand davon, oder eine Nukleinsäure, insbesondere ein DNA- oder RNA-Fragment, ist und/oder

(c) der Einlagerungsabschnitt eine molekulare Struktur, die Xenon bindet, ist, insbesondere ein Protein, ein Peptid, eine Nukleinsäure, ein Fragment oder Komplexe davon, oder eine sonstige organische oder synthetische Verbindung, insbesondere Cucurbiturile, Cryptophane oder Pillararene.

10. Verfahren nach einem der vorstehenden Ansprüche, **dadurch gekennzeichnet, dass** die Wirtsmolekül-Konzentration ($C^{tot}$) höchstens 500 Nanomol pro Liter, insbesondere höchstens 10 Nanomol pro Liter oder 1 Nanomol pro Liter, beträgt oder sogar im Bereich Picomol pro Liter liegt.

11. Verfahren nach einem der vorstehenden Ansprüche, **dadurch gekennzeichnet, dass** die xenonhaltigen Lösungen (16) hergestellt werden durch Verändern der Xenon-Konzentration (sp) ohne Veränderung der Wirtsmolekül-Konzentration ($C^{tot}$).

12. Konzentrationsmessgerät (22) zum quantitativen Bestimmen einer Wirtsmolekül-Konzentration ($C^{tot}$) an Wirtsmolekülen (10) in einer Lösung (16), mit

(i) einer Magnetresonanzmesseinheit (32), die ausgebildet ist zum automatischen

Bestrahlen der xenonhaltigen Lösung (16) mit elektromagnetischer Depolarisierungs-Strahlung (18) und Messen einer Signalintensität eines Hochfrequenzsignals (20) bei einer Resonanz-Frequenz ($f_R$) des gelösten Xenons, und

(ii) einer Recheneinheit (34),
(iii) **dadurch gekennzeichnet, dass** das Konzentrationsmessgerät (22) eine Einbringvorrichtung (28) aufweist, die ausgebildet ist zum Einstellen einer Xenon-Konzentration durch Einbringen von Xenon in die Lösung,
(iv) die Recheneinheit (34) ausgebildet ist zum automatischen Durchführen eines Verfahrens mit den Schritten:

(a) Ansteuern der Einbringvorrichtung (28), sodass die Xenon-Konzentration ($s \cdot p$) einen vorgegebenen Wert hat,
(b) Ansteuern der Magnetresonanzmesseinheit (32), sodass diese Depolarisierungs-Strahlung (18) mit einer Wirtskomplex-Frequenz (fw) und einer Bestrahlungsamplitude (v) und Dauer (t) abgibt,
(c) Erfassen einer Xenon-Konzentration ($s \cdot p$) des in der Lösung (16) gelösten Xenons,
(d) Erfassen der Signalintensitäten (S) des Hochfrequenzsignals (20) zu zumindest zwei unterschiedlichen Zeitpunkten der Bestrahlung und
(e) Berechnen der Wirtsmolekül-Konzentration ($C^{tot}$) aus den Signalintensitäten, den Xenon-Konzentrationen (sp), der Bestrahlungsamplituden (v) und gegebenenfalls Bestrahlungszeiten (t).

13. Konzentrationsmessgerät (22) nach Anspruch 12, **gekennzeichnet durch**

(a) die Einbringvorrichtung (28) zum automatischen Einbringen von hyperpolarisiertem Xenon in die Lösung (16) ausgebildet ist und
(b) einen Konzentrationsmesser (40) zum Erfassen der Xenon-Konzentration ($s \cdot p$) in der Lösung (16),
(c) wobei die Recheneinheit (34) ausgebildet ist zum automatischen Verändern der Xenon-Konzentration (p) und/oder der Bestrahlungsamplitude (v) und Bestrahlungszeit (t) gemäß einem vorgegebenen Messplan.

14. Konzentrationsmessgerät (22) nach Anspruch 13, **gekennzeichnet durch**

(a) eine Xenon-Hyperpolarisationsvorrichtung (38) zum Erzeugen von hyperpolarisiertem Xenon, die mit der Einbringvorrichtung (28) zum Zuführen des hyperpolarisierten Xenons verbunden ist.
(b) wobei die Recheneinheit (34) eingerichtet ist zum automatischen Durchführen eines Verfahrens gemäß einem der Ansprüche 1 bis 11.

**Claims**

1. A method to quantitatively determine a host molecule concentration ($C^{tot}$) of host molecules (10) comprising the steps:

(a) introducing hyperpolarised xenon into a solution (16) of host molecules (10), resulting in a solution containing xenon (16), which contains dissolved xenon and xenon in a host molecule-xenon complex (14) with a host molecule (10),

(b) irradiating the solution containing xenon (16) with electromagnetic depolarisation radiation (18) with a host complex frequency (fw) for the at least partially selective depolarisation of xenon and host molecule-xenon complex (14), and

(c) subsequently measuring a signal intensity (S) of a high-frequency signal (20) at least in a frequency interval around a resonance frequency ($f_R$) of the dissolved xenon, at at least two different points in time during irradiation (t),

**characterised by** the steps:

(d) irradiating solutions containing xenon (16) of various xenon concentrations of dissolved xenon with depolarisation radiation (18) of various irradiation amplitudes (v) and detecting the respective signal intensities (S) and

(e) determining the host molecule concentration ($C^{tot}$) from the signal intensities (S), the xenon concentrations and the irradiation amplitudes (v).

2. The method according to claim 1, **characterised in that**

(a) the host molecule concentration ($C^{tot}$) is only determined from the signal intensities (S), the xenon concentrations ($s \cdot p$) and the irradiation amplitudes (v) or

(b) the solutions containing xenon (16) of various xenon concentrations ($s \cdot p$) of dissolved xenon are irradiated with depolarisation radiation (18) of various irradiation amplitudes (v) and various irradiation times (t) and the host molecule concentration ($C^{tot}$) is determined from the signal intensities (S), the xenon concentrations (sp), the irradiation amplitudes (v) and the irradiation times (t)

wherein s is the xenon solubility and p the xenon partial pressure.

3. The method according to claim 1 or 2, **characterised by** the steps:

(a) measuring the signal intensity at various xenon concentrations ($s \cdot p$) and various irradiation amplitudes (v) at various points in time during irradiation (t), thereby obtaining signal intensity measurement data (S) as a function of concentration, irradiation amplitude and time,

(b) calculating effective temporal decay rates ($\delta(p,v)$) from the signal intensities (S) for a given xenon concentration ($s \cdot p$) and irradiation amplitude v and

(c) calculating a xenon leakage rate $k_{off}(p)$ and a xenon entry rate $k_{on}(p)$ as a function of the xenon concentration ($s \cdot p$)

by adjusting the effective decay rate ($\delta(p,v)$) to the following formula by minimising the square error

$$\delta(p, v) = k_{on}(p) \frac{(2\pi v)^2}{(2\pi v)^2 + k_{off}(p)^2} \, ,$$

(d) as well as determining at least the host molecule concentration $C^{tot}$ of host molecules (10) by adjusting the xenon leakage rates ($k_{off}(p)$) and the xenon entry rates ($k_{on}(p)$) to the formula

$$\frac{k_{off}(p)}{k_{on}(p)} = \frac{1}{K C^{tot}} + \frac{s}{C^{tot}} p,$$

wherein s is the xenon solubility and K a binding constant.

4. The method according to claim 3, **characterised in that** in addition

(a) a binding constant K, which describes a binding strength of xenon to the host molecule (10), is determined by adjusting it to the following formula by minimising the square error:

$$\frac{k_{off}(p)}{k_{on}(p)} = \frac{1}{K C^{tot}} + \frac{s}{C^{tot}} p \, ,$$

(b) a dissociation rate coefficient c_ and
(c) a rate coefficient (k) k for degenerate exchange are determined by adjusting them to the following formula by minimising the square error: $k_{off}(p) = c_- + ksp$.

5. The method according to one of the preceding claims, **characterised by** the steps:

(a) measuring the signal intensity at various xenon concentrations (s·p) and various irradiation amplitudes (v) at various points in time during irradiation (t), thereby obtaining signal intensity measurement data (S) as a function of concentration, irradiation amplitude and time,
(b) calculating the effective temporal decay rates $(\delta(p,v))$ from the signal intensities (S) for a given xenon concentration and irradiation amplitude,
(c) calculating

the host molecule concentration $C^{tot}$,
of the dissociation rate coefficient c_,
of the rate coefficient k for degenerate exchange and
of the binding constant K
by adjusting the effective temporal decay rates $(\delta(p,v))$ to the formula

$$\delta(p,v) = (c_- + ksp)\frac{KC^{tot}}{1+Ksp}\frac{(2\pi v)^2}{(2\pi v)^2+(c_-+ksp)^2}.$$

6. The method according to one of the preceding claims, **characterised by**

(a) measuring a reference signal intensity at various xenon concentrations (sp) and various irradiation amplitudes (v) at various points in time during irradiation (t) at a mirror symmetric frequency, which is the sum of (i) a resonance frequency $(f_R)$ of the dissolved xenon and (ii) the difference from the resonance frequency $(f_R)$ and the host complex frequency (fw), thereby obtaining reference signal intensity measurement data as a function of concentration, irradiation and time $(S_R)$,
(b) calculating an effective temporal reference decay rate ((p,v)) from the reference signal intensities (S) for a given xenon concentration and irradiation amplitude, and
(c) deducting the reference decay rate (R(p,v)) from the effective decay rate $(\delta(p,v))$ for a given xenon concentration (s·p) and irradiation amplitude (v).

7. The method according to one of the preceding claims, **characterised by** the steps:

(a) measuring the signal intensity at various xenon concentrations (s.p) and various irradiation amplitudes (v) at various points in time during irradiation (t), thereby obtaining signal intensity measurement data (S) as a function of concentration, irradiation amplitude and time,
(b) calculating at least the host molecule concentration $C^{tot}$,

the dissociation rate coefficient c_,
a rate coefficient k for degenerate exchange,
the binding constant K and
the signal amplitude A,
a parameter $\alpha$ that describes the generation of hyperpolarisation, by adjusting the measured signal intensities to the following formula by minimising the square error:

$$S(p,v,t) \propto \frac{Asp}{1+ap}\exp\left\{-\left((c_- + ksp)\frac{KC^{tot}}{1+Ksp}\frac{(2\pi v)^2}{(2\pi v)^2+(c_-+ksp)^2}\right)t\right\}$$

8. The method according to claim 7, **characterised by**

(a) measuring time-dependent reference signal intensities $(S_R)$ at various xenon concentrations (s·p) and various irradiation amplitudes (v) at various points in time during irradiation (t) at the mirror symmetrical frequency,
(b) calculating the reference decay rate in the time (R(p,v)) from the reference signal intensities $(S_R)$ for a given xenon concentration and irradiation amplitude, and

(c) fitting the signal intensities (S) to the following formula using the reference decay rate (R(p,v)) by minimising the square error

$$S(p, v, t) \propto \frac{Asp}{1+ap} \exp\left\{-\left((c_- + ksp)\frac{KC^{tot}}{1+Ksp}\frac{(2\pi v)^2}{(2\pi v)^2+(c_-+ksp)^2} + R(p,v)\right)t\right\}.$$

9. The method according to one of the preceding claims, **characterised in that**

   (a) the host molecule (10) comprises

      a receptor molecule section for binding a target molecule,
      a deposit molecule section and
      a target molecule that is attached to the receptor molecule section,

   (b) the receptor molecule section is a protein or peptide, especially an enzyme, an antibody, a fragment or a ligand thereof, or a nucleic acid, especially a DNA or RNA fragment, and/or
   (c) the deposit section has a molecular structure that binds xenon, especially a protein, a peptide, a nucleic acid, a fragment or complexes thereof, or another organic or synthetic compound, especially cucurbiturils, cryptophanes or pillararenes.

10. The method according to one of the preceding claims, **characterised in that** the host molecule concentration ($C^{tot}$) is at most 500 nanomol per litre, in particular at most 10 nanomol per litre oder 1 nanomol per litre, or even lies in the picomol per litre range.

11. The method according to one of the preceding claims, **characterised in that** the solution containing xenon (16) is produced by changing the xenon concentration (sp) without changing the host molecule concentration ($C^{tot}$).

12. A concentration measurement device (22) for quantitatively determining a host molecule concentration ($C^{tot}$) of host molecules (10) in a solution (16), with

   (i) a magnet resonance measurement unit (32) designed to automatically irradiate the solution containing xenon (16) with electromagnetic depolarisation radiation (18) and
   measure a signal intensity of a high-frequency signal (20) at a resonance frequency ($f_R$) of the dissolved xenon, and
   (ii) a computing unit (34),
   (iii) **characterised in that** the concentration measurement device (22) comprises an insertion device (28) designed to automatically adjust a xenon concentration by introducing xenon into the solution,
   (iv) the computing unit (34) is configured to automatically carry out a method comprising the steps:

      (a) controlling the insertion device (28) such that the xenon concentration ($s{\cdot}p$) has a predetermined value,
      (b) controlling the magnet resonance measurement unit (32) such that it emits depolarisation radiation (18) with a host complex frequency (fw) and irradiation amplitude (v) and duration (t),
      (c) detecting a xenon concentration (sp) of the xenon dissolved in the solution (16),
      (d) detecting the signal intensities (S) of the high-frequency signal (20) at at least two different points in time during irradiation, and
      (e) calculating the host molecule concentration ($C^{tot}$) from the signal intensities, the xenon concentrations (sp), the irradiation amplitudes (v) and, where possible, irradiation times (t).

13. A concentration measurement device (22) according to claim 12, **characterised by**

   (a) the insertion device (28) for automatically introducing hyperpolarised xenon into the solution (16) and
   (b) a concentration gauge (40) for detecting the xenon concentration ($s{\cdot}p$) in the solution (16),
   (c) wherein the computing unit (34) is designed to automatically change the xenon concentration (p) and/or the irradiation amplitude (v) and irradiation time (t) according to a predetermined measurement plan.

**14.** A concentration measurement device (22) according to claim 13, **characterised by**

(a) a xenon hyperpolarisation device (38) for generating hyperpolarised xenon that is connected to the insertion device (28) for supplying the hyperpolarised xenon.
(b) wherein the computing unit (34) is configured to automatically carry out a method according to one of the claims 1 to 11.

**Revendications**

**1.** Procédé de détermination quantitative d'une concentration en molécules hôtes ($C^{tot}$) de molécules hôtes (10), comprenant les étapes consistant à:

(a) introduire du xénon hyperpolarisé dans une solution (16) de molécules hôtes (10), de manière à obtenir une solution contenant du xénon (16) qui contient du xénon dissous et du xénon dans un complexe molécule hôte-xénon (14) avec une molécule hôte (10),
(b) irradier la solution contenant du xénon (16) avec un rayonnement de dépolarisation électromagnétique (18) à une fréquence de complexe hôte (fw) pour la dépolarisation sélective au moins partielle du xénon dans le complexe molécule hôte-xénon (14), et
(c) mesurer ensuite l'intensité de signal (S) d'un signal radiofréquence (20) dans au moins un intervalle de fréquence autour d'une fréquence de résonance ($f_R$) du xénon dissous, à au moins deux instants d'irradiation (t) différents,

**caractérisé par** les étapes consistant à :

(d) irradier des solutions contenant du xénon (16), ayant différentes concentrations en xénon dissous, avec un rayonnement de dépolarisation (18) ayant différentes amplitudes d'irradiation (v), et détecter les intensités de signal (S) respectives, et
(e) déterminer la concentration en molécules hôtes (Ctot) à partir des intensités de signal (S), des concentrations en xénon et des amplitudes d'irradiation (v).

**2.** Procédé selon la revendication 1, **caractérisé en ce que**

(a) la concentration en molécules hôtes ($C^{tot}$) est déterminée uniquement à partir des intensités de signal (S), des concentrations en xénon (sp) et des amplitudes d'irradiation (v), ou
(b) l'irradiation des solutions contenant du xénon (16) ayant différentes concentrations en xénon (sp) de xénon dissous est réalisée avec un rayonnement de dépolarisation (18) ayant des amplitudes d'irradiation (v) et des temps d'irradiation (t) différents, et

la détermination de la concentration en molécules hôtes ($C^{tot}$) est réalisée à partir des intensités de signal (S), des concentrations en xénon ($s \cdot p$), des amplitudes d'irradiation (v) et des temps d'irradiation (t), où s est la solubilité du xénon et p est la pression partielle du xénon.

**3.** Procédé selon la revendication 1 ou 2, **caractérisé par** les étapes consistant à :

(a) mesurer l'intensité du signal à différentes concentrations en xénon (*sp*) et à différentes amplitudes d'irradiation (v), à des instants d'irradiation respectifs (t) différents, de manière à obtenir des données de mesure d'intensité de signal (S) dépendant de la concentration, de l'amplitude d'irradiation et du temps,
(b) calculer des taux de décroissance temporels effectifs ($\delta(p,v)$) à partir des intensités de signal (S) pour une concentration en xénon (sp) et une amplitude d'irradiation v données, et
(c) calculer un taux de sortie de xénon $k_{off}(p)$ et un taux d'entrée de xénon $k_{on}(p)$ en fonction de la concentration en xénon ($s \cdot p$) en adaptant les taux de décroissance effectifs ($\delta(p,v)$), par minimisation de l'erreur quadratique, à la formule

$$\delta(p,v) = k_{on}(p)\frac{(2\pi v)^2}{(2\pi v)^2 + k_{off}(p)^2},$$

(d) et déterminer au moins la concentration en molécules hôtes $C^{tot}$ des molécules hôtes (10) en adaptant les taux de sortie de xénon ($k_{off}(p)$) et les taux d'entrée de xénon ($k_{on}(p)$) à la formule

$$\frac{k_{off}(p)}{k_{on}(p)} = \frac{1}{KC^{tot}} + \frac{s}{C^{tot}}p,$$

où s est la solubilité du xénon et K est une constante de liaison.

4. Procédé selon la revendication 3, **caractérisé en outre en ce que**

(a) une constante de liaison K, décrivant une force de liaison du xénon à la molécule hôte (10), est déterminée en l'adaptant, par minimisation de l'erreur quadratique, à la formule

$$\frac{k_{off}(p)}{k_{on}(p)} = \frac{1}{KC^{tot}} + \frac{s}{C^{tot}}p,$$

(b) un coefficient de taux de dissociation c_ et
(c) un coefficient de taux (k) k pour l'échange dégénéré sont déterminés en les adaptant, par minimisation de l'erreur quadratique, à la formule

$$k_{off}(p) = c_- + ksp.$$

5. Procédé selon l'une des revendications précédentes, **caractérisé par** les étapes consistant à :

(a) mesurer l'intensité du signal à différentes concentrations en xénon ($s \cdot p$) et à différentes amplitudes d'irradiation (v), à des instants d'irradiation respectifs (t) différents, de manière à obtenir des données de mesure d'intensité de signal (S) dépendant de la concentration, de l'amplitude d'irradiation et du temps,
(b) calculer les taux de décroissance temporels effectifs ($\delta(p,v)$) à partir des intensités de signal (S) pour une concentration en xénon et une amplitude d'irradiation données,
(c) calculer

la concentration en molécules hôtes $C^{tot}$,
le coefficient de taux de dissociation c_,
le coefficient de taux k pour l'échange dégénéré, et
la constante de liaison K
en adaptant les taux de décroissance temporels effectifs ($\delta(p,v)$) à la formule

$$\delta(p,v) = (c_- + ksp)\frac{KC^{tot}}{1+Ksp}\frac{(2\pi v)^2}{(2\pi v)^2+(c_-+ksp)^2}.$$

6. Procédé selon l'une des revendications précédentes, **caractérisé par** les étapes consistant à :

(a) mesurer une intensité de signal de référence à différentes concentrations en xénon ($s \cdot p$) et à différentes amplitudes d'irradiation (v), à des instants d'irradiation respectifs (t) différents, à une fréquence de symétrie miroir qui est la somme de (i) la fréquence de résonance ($f_R$) du xénon dissous et de (ii) la différence entre la fréquence de résonance ($f_R$) et la fréquence du complexe hôte (fw), de manière à obtenir des données de mesure de l'intensité de signal de référence ($S_R$) dépendant de la concentration, de l'amplitude d'irradiation et du temps,
(b) calculer un taux de décroissance temporel de référence (R(p,v)) à partir des intensités de signal de référence ($S_R$) pour une concentration en xénon et une amplitude d'irradiation données, et
(c) soustraire le taux de décroissance de référence (R(p,v)) du taux de décroissance effectif ($\delta(p,v)$) pour une concentration en xénon ($s \cdot p$) et une amplitude d'irradiation (v) données.

7. Procédé selon l'une des revendications précédentes, **caractérisé par** les étapes consistant à :

(a) mesurer l'intensité du signal à différentes concentrations en xénon ($s \cdot p$) et à différentes amplitudes d'irradiation (v), à des instants d'irradiation respectifs (t) différents, de manière à obtenir des données de mesure d'intensité de signal (S) dépendant de la concentration, de l'amplitude d'irradiation et du temps,
(b) calculer au moins la concentration en molécules hôtes $C^{tot}$,

le coefficient de taux de dissociation $c\_$,
un coefficient de taux $k$ pour l'échange dégénéré,
la constante de liaison $K$ et
l'amplitude de signal $A$,
d'un paramètre $\alpha$ décrivant la génération de l'hyperpolarisation, en adaptant les intensités de signal mesurées, par minimisation de l'erreur quadratique, à la formule :

$$S(p, v, t) \propto \frac{Asp}{1+ap} \exp\left\{-\left((c_- + ksp)\frac{KC^{tot}}{1+Ksp}\frac{(2\pi v)^2}{(2\pi v)^2+(c_-+ksp)^2}\right)t\right\}$$

8.  Procédé selon la revendication 7, **caractérisé par** les étapes consistant à :

    (a) mesurer les intensités de signal de référence ($S_R$) dépendant du temps à différentes concentrations en xénon (sp) et à différentes amplitudes d'irradiation (v), à des instants d'irradiation respectifs (t) différents, à la fréquence de symétrie miroir,
    (b) calculer le taux de décroissance de référence dans le temps (R(p,v)) à partir des intensités de signal de référence ($S_R$) pour une concentration en xénon et une amplitude d'irradiation données, et
    (c) adapter les intensités de signal (S) en utilisant le taux de décroissance de référence (R(p,v)), par minimisation de l'erreur quadratique, à la formule :

$$S(p, v, t) \propto \frac{Asp}{1+ap} \exp\left\{-\left((c_- + ksp)\frac{KC^{tot}}{1+Ksp}\frac{(2\pi v)^2}{(2\pi v)^2+(c_-+ksp)^2} + R(p, v)\right)t\right\}$$

9.  Procédé selon l'une des revendications précédentes, **caractérisé en ce que**

    (a) la molécule hôte (10) présente

        un segment de molécule récepteur destiné à se lier à une molécule cible,
        un segment de molécule interstitiel, et
        une molécule cible liée au segment de molécule récepteur,

    (b) le segment de molécule récepteur est une protéine ou un peptide, en particulier une enzyme, un anticorps, un fragment ou un ligand de ceux-ci, ou un acide nucléique, en particulier un fragment d'ADN ou d'ARN, et/ou
    (c) le segment interstitiel est une structure moléculaire qui se lie au xénon, en particulier une protéine, un peptide, un acide nucléique, un fragment ou un complexe de ceux-ci, ou un autre composé organique ou synthétique, en particulier des cucurbituriles, des cryptophanes ou des pillararènes.

10. Procédé selon l'une des revendications précédentes, **caractérisé en ce que** la concentration en molécules hôtes ($C^{tot}$) est d'au plus 500 nanomoles par litre, en particulier d'au plus 10 nanomoles par litre ou de 1 nanomole par litre, voire de l'ordre du picomole par litre.

11. Procédé selon l'une des revendications précédentes, **caractérisé en ce que** les solutions contenant du xénon (16) sont préparées en modifiant la concentration en xénon ($s \cdot p$) sans modifier la concentration en molécules hôtes ($C^{tot}$).

12. Dispositif de mesure de concentration (22) permettant la détermination quantitative d'une concentration en molécules hôtes ($C^{tot}$) de molécules hôtes (10) dans une solution (16), comprenant

    (i) une unité de mesure par résonance magnétique (32) conçue pour automatiquement
    (ii) irradier la solution contenant du xénon (16) avec un rayonnement de dépolarisation électromagnétique (18), et
    (iii) mesurer une intensité de signal d'un signal haute fréquence (20) à une fréquence de résonance ($f_R$) du xénon dissous, et

(iv) une unité de calcul (34),

(v) **caractérisé en ce que** le dispositif de mesure de concentration (22) comporte un dispositif d'introduction (28) conçu pour ajuster une concentration en xénon par introduction de xénon dans la solution,

(vi) l'unité de calcul (34) est conçue pour mettre en œuvre automatiquement un procédé comprenant les étapes consistant à :

(a) commander le dispositif d'introduction (28) de manière à ce que la concentration en xénon ($s \cdot p$) présente une valeur prédéterminée,

(b) commander l'unité de mesure par résonance magnétique (32) de manière à ce que celle-ci émette un rayonnement de dépolarisation (18) à une fréquence de complexe hôte (fw) et à une amplitude d'irradiation (v) et pendant une durée (t),

(c) détecter la concentration en xénon ($s \cdot p$) du xénon dissous dans la solution (16),

(d) détecter les intensités de signal (S) du signal radiofréquence (20) à au moins deux instants d'irradiation différents, et

(e) calculer la concentration en molécules hôtes ($C^{tot}$) à partir des intensités de signal, des concentrations en xénon ($s \cdot p$), des amplitudes d'irradiation (v) et, le cas échéant, des temps d'irradiation (t).

13. Dispositif de mesure de concentration (22) selon la revendication 12, **caractérisé par**

(a) un dispositif d'introduction (28) conçu pour introduire automatiquement du xénon hyperpolarisé dans la solution (16), et

(b) un dispositif de mesure de concentration (40) pour détecter la concentration en xénon (sp) dans la solution (16),

(c) l'unité de calcul (34) étant conçue pour modifier automatiquement la concentration en xénon (p) et/ou l'amplitude d'irradiation (v) et le temps d'irradiation (t) selon un plan de mesure prédéterminé.

14. Dispositif de mesure de concentration (22) selon la revendication 13, **caractérisé par**

(a) un dispositif d'hyperpolarisation du xénon (38) pour générer du xénon hyperpolarisé, qui est relié au dispositif d'introduction (28) pour l'alimentation en xénon hyperpolarisé,

(b) l'unité de calcul (34) étant conçue pour mettre en œuvre automatiquement un procédé selon l'une des revendications 1 à 11.

Fig. 1a

Xe + CB6 $\underset{C_-}{\overset{C_+}{\rightleftharpoons}}$ Xe:CB6

*Xe + Xe:CB6$_k$ $\longleftrightarrow$ Xe + *Xe:CB6

Fig. 1b

Fig. 1c

Fig. 1d

Fig. 1

Fig. 2

Fig. 3a

Fig. 3b

EP 4 388 305 B1

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3330729 A1

**In der Beschreibung aufgeführte Nicht-Patentliteratur**

- **S. KORCHAK et al.** Quantitative biosensor detection by chemically exchanging hyperpolarized Xe. *Phys. Chem. Chem. Phys*, 2018, vol. 20, 1800